Europäisches Patentamt

European Patent Office

Office européen des brevets

(19)

(11) **EP 0 894 332 B1**

(12) **EUROPÄISCHE PATENTSCHRIFT**

(45) Veröffentlichungstag und Bekanntmachung des Hinweises auf die Patenterteilung:
**21.05.2003 Patentblatt 2003/21**

(51) Int Cl.⁷: $H01J\ 37/32$, $B05D\ 3/14$, $C09J\ 5/02$, $B23K\ 1/20$

(21) Anmeldenummer: **97915247.7**

(22) Anmeldetag: **14.04.1997**

(86) Internationale Anmeldenummer:
**PCT/CH97/00147**

(87) Internationale Veröffentlichungsnummer:
**WO 97/039472 (23.10.1997 Gazette 1997/45)**

(54) **VERWENDUNG VERBINDUNGSVERFAHRENS UND VERBINDUNGSVERFAHREN**

USE OF A CONNECTING PROCESS AND CONNECTING PROCESS

UTILISATION D'UN PROCEDE D'ASSEMBLAGE ET PROCEDE D'ASSEMBLAGE

(84) Benannte Vertragsstaaten:
**DE FR GB IE IT**

(30) Priorität: **15.04.1996 CH 94896**

(43) Veröffentlichungstag der Anmeldung:
**03.02.1999 Patentblatt 1999/05**

(73) Patentinhaber:
• **Unaxis Balzers Aktiengesellschaft**
**9496 Balzers (LI)**
• **ESEC SA**
**6330 Cham (CH)**

(72) Erfinder:
• **DOMMANN, Alex**
**CH-9470 Buchs (CH)**
• **LUECHINGER-BAUTISTA, Christoph, Benno**
**CH-6403 Küssnacht am Rigi (CH)**

• **ONDA, Nicolino**
**CH-8049 Zürich (CH)**
• **RAMM, Jürgen**
**CH-9475 Sevelen (CH)**
• **ZIMMERMANN, Heinrich**
**CH-9470 Werdenberg (CH)**

(74) Vertreter: **Troesch Scheidegger Werner AG**
**Patentanwälte**
**Postfach**
**8032 Zürich (CH)**

(56) Entgegenhaltungen:
EP-A- 0 371 693          EP-A- 0 427 020
EP-A- 0 510 340          GB-A- 2 267 387
US-A- 5 409 543

• PATENT ABSTRACTS OF JAPAN vol. 014, no. 383 (E-0966), 17.August 1990 & JP 02 140925 A (NEC CORP), 30.Mai 1990,

**Beschreibung**

Die vorliegende Erfindung betriff ein Verfahren zur Herstellung von Werkstücken, bei dem Oberflächen von Teilen Luft ausgesetzt werden und danach ohne weitere zusätzliche Behandlung gebondet, geklebt oder vergossen werden und sie hierfür vor dem Luftaussetzen einer Atmosphäre mit aktiviertem Wasserstoff ausgesetzt werden.

Definition:

Als innige Verbindungsverfahren werden Bonden (Schweissen, Löten) sowie Kleben verstanden. Die Oberflächen können Metalloberflächen, insbesondere Cu, Ni, Ag, Au, Pd, Si sein oder Kunststoff-Oberflächen, wie auf Epoxi- oder Esterbasis. Solche Oberflächen sind oft durch Oxide, Nitride oder auch Polyimide belegt. Die Energiezufuhr für die genannten Verbindungen ist grundsätzlich thermischer Art und wird, z.B. mittels beheizter Werkzeuge, Joulscher Wärme, UV-strahlung oder vorzugsweise durch Ultraschall den zu verbindenden Oberflächen zugeführt oder durch Reaktionsenergie beim Kleben.

Passivierung bzw. passiviert: siehe Römpps Chemie-Lexikon, Franckh'sche Verlagshandlung Stuttgart, Ausgabe 8, S. 3005.

Darunter wird eine gebundene Schutzbelegung der Grundkörper-Oberfläche verstanden. Die saubere Grundkörper-Oberfläche wird vor athmosphärischen Lufteinflüssen geschützt. Dies erfolgt z.B. durch Bildung einer Oxid- oder Nitridschicht. Eine solche Schicht muss für die Erstellung einer Verbindung obgenannter Art erst durch eigens dafür aufzubringende Energie aufgeschlossen werden, beispielsweise durch Aufbringen höherer Temperaturen, als für den eigentlichen Verbindungsvorgang erforderlich, oder chemisch, z.B. durch Einsatz eines Flussmittels.

Vom genannten Passivieren unterscheiden wir grundsätzlich das Konservieren, welches insbesondere keinen Schichtaufschluss durch zusätzliche Energie beim Verbinden erfordert. Diese Konservierung ist erst im Zusammenhang mit und durch vorliegende Erfindung erkannt worden.

Die vorliegende Erfindung wird insbesondere vorteilhafterweise beim Verpacken von integrierten Schaltungen eingesetzt.

Beim sogenannten Verpacken von integrierten Schaltungen werden mehrere Arbeitsgänge unterschieden, welche ein Verbinden von Oberflächen in obgenanntem Sinne umfassen:

1. Die einzelnen integrierten Schaltkreise werden aus einem Siliziumwafer herausgeschnitten und auf Halbleiter-Systemträger (HLST) aufgebracht und mit diesen verbunden (sog. Die-Bonding). Die HLST-Oberflache ist üblicherweise aus Kupfer oder aus Nickel, Silber oder Gold oder aus einem Material auf Epoxybasis, generell aus einem Kunststoff. Beispiele solcher HLST sind gestanzte oder geätzte metallische lead frames, keramische Substrate oder BGA (ball grid array) Substratträger aus Kunststoff. Als Verbindungsverfahren werden Hartlöten, Weichlöten und Kleben eingesetzt. Bei Flip Chip Solder Prozessen wird die integrierte Schaltung auf einen HLST mittels geometrisch getrennter solder balls aufgebracht, welche gleichzeitig als I/O-Kontaktieru benutzt werden.

2. Verbinden der integrierten Schaltkreise mit Kontaktstützpunkten am HLST, wie z.B. am lead frame; Die beteiligten Oberflächen sind metallisch, wie aus Al, Au, Cu, Ni, Pd. Hier werden als Verbindungstechniken vornehmlich Löten oder Schweissen, dabei insbesondere flussmittelfreies Löten oder Ultraschallschweissen eingesetzt.
Dieser Schritt ist als Wire Bonding (Draht-Bonden) bekannt.

3. Vergiessen (Moulding): Bei diesem Verfahrensschritt werden die Schaltkreise auf den HLST, z.B. den lead frames, nach dem wire bonding, mit einer Vergussmasse vergossen, wobei bezüglich Vergussmasse die obgenannten Oberflächen von HLST und integrierten Schaltkreisen beteiligt sind.

Aus der EP-0 371 693 ist, im Rahmen eines Verbindungsverfahrens für metallische Oberflächen, ein Reinigungsverfahren bekannt, bei dem die nachmals im obgenannten Sinne allein durch Zuführung von Energie zu verbindenden Oberflächen erst einer Mikrowellen-Plasmaentladung in einer wasserstoffenthaltenden Vakuumatmosphäre ausgesetzt werden. Darnach wird, ohne Vakuumunterbruch, mittels der Plasmaentladung die vorgesehene Lotschicht zum Verbinden der Oberflächen aufgeschmolzen. Somit wird durch Vermeidung von Luftkontakt eine verunreinigende Oberflächenbelegung verhindert, welche den anschliessenden Verbindungsprozess empfindlich stören würde.

Aus der US-5 409 543 ist es weiter bekannt, aktivierten Wasserstoff zur Vorbereitung eines Lötvorganges einzusetzen. Dadurch wird eine Oxid-Schicht aufgeschlossen, für den Durchgriff des Lötvorganges auf die Metalloberfläche.

Aus der EP-A-0 427 020 ist es weiter bekannt, eine Passivund Oxidschicht von Fügepartnern mittels einer Hochfrequenz-Plasmavorbehandlung mit einem Prozessgas zu dekapieren, d.h. aufzuschliessen. Als Prozessgase werden Gase bzw. Gasmischungen u.a. aus $O_2$, $H_2$, $Cl_2$, $N_2O$, $N_2$, $CF_4$ etc. eingesetzt.

Erfolgt das erwähnte Dekapieren nicht wie bei der US-A-5 409 543 unmittelbar vor dem Lötvorgang, so werden die Fügepartner in Schutz-Zwischenspeichern gelagert, wozu, zur Verhinderung einer Kontamination, geeignete Behältnisse unter Schutzgas vorgesehen werden.

Die vorliegende Erfindung unter ihrem ersten Aspekt beruht darauf, dass das Reinigungsverfahren der genannten Art grundsätzlich in einer Atmosphäre - vorzugsweise in einer Vakuumatmosphäre - mit angeregtem Wasserstoff zu einer Konservierung der Oberflächen bezüglich Luft führt. Diese Konservierung erlaubt es, die Oberflächen nach "Reinigung" und vor ihrem Verbinden an Luft sogar zu lagern, ohne dass die vorerwähnten Nachteile betreffs Verbindbarkeit aufträten: Die nachmals vorgenommene Verbindung fällt qualitativ nicht schlechter aus, als wenn sie direkt im Vakuum des Reinigungsschrittes oder, generell, ohne die Oberflächen der Luft auszusetzen, erstellt worden wäre.

Oft sind vorzunehmenden Reinigungsverfahren für nachmals im , obgenannten Sinne zu verbindende Oberflächen durch die thermische Belastbarkeit der beteiligten Teile Grenzen gesetzt. Dies trifft insbesondere zu, wenn die einen Oberflächen Flächen der genannten integrierten Schaltungen sind.

Alle Prozesse der obgenannten IC-Verpackung sind kritisch, insbesondere, falls aus Kostengründen bestimmte HLST-Materialien benutzt werden sollen. Organische HLST-Materialien dürfen keinen hohen Temperaturen ausgesetzt werden. Zusätzlich besteht die Tendenz, dass sich die Anzahl der elektrischen Anschlüsse der integrierten Schaltungen ständig vergrössert, bei gleichzeitiger Verringerung des Querschnittes der Anschlussdrähte, wofür eine hohe Reproduzierbarkeit der Einzelverbindungen sichergestellt werden muss.

Unter einem zweiten Aspekt setzt sich die vorliegende Erfindung, ausgehend vom obgenannten Reinigungsverfahren grundsätzlicher Art, zum Ziel, nebst einer hohen Verbindungsreproduzierbarkeit, effizient angeregten Wasserstoff zu erzeugen, aber dabei gleichzeitig die thermische Belastung der behandelten Oberflächen möglichst gering zu halten. Dies wird dadurch erreicht, dass, wenn eine Plasmaentladung zur Aktivierung des Wasserstoffes eingesetzt wird, diese vorzugsweise als Niederspannungsentladung realisiert wird. Der Wasserstoff kann aber auch auf andere Art angeregt werden, wie durch Strahlung bestimmter Energie bzw. Wellenlänge, wie insbesondere durch UV-Strahlung.

Definition:

Als Niederspannungsentladung wird eine Plasmaentladung verstanden, bei welcher über einer Kathoden/Anodenstrecke eine DC-Entladung betrieben wird, wobei die Kathode als thermionische Kathode (Heisskathode) betrieben wird.

Unter einem dritten Aspekt betrifft die vorliegende Erfindung; ein Verbindungsverfahren eingangs genannter Art, bei welchem die vormals vorzugsweise in einem Vakuumprozess gereinigten und erfindungsgemäss konservierten Oberflächen Luft ausgesetzt werden, bevor sie dem erwähnten Verbindungsprozess unterzogen werden. Es versteht sich von selbst, dass damit eine; hohe Fertigungsflexibilität erreicht wird.

Eine erfindungsgemässe Werkstückpaarung, die dies erlaubt, ist in Anspruch 14 bzw. 16 definiert, ein erfindungsgemässes Werkstück in Anspruch 15.

Es kann, entfernt mit der vorliegenden Erfindung im Zusammenhang stehend, auf folgendes Schrifttum verwiesen werden:

- Research disclosure 307 107, worin, im Zusammenhang mit einem Härtungsverfahren, eine harte Schicht durch Elektronenstrahl-Oberflächenbeaufschlagung erzeugt wird;

- GB-2 131 619, wonach mechanisch belastete elektrische Kontaktflächen von Schaltkontakten zur Reinigung einer Plasmaentladung, vorzugsweise einer Hf-Plasmaentladung, in einer wasserstoff-, sauerstoff-, schwefelhexafluoridetc. enthaltenden Atmosphäre gereinigt werden;

- S. Veprek et al., "Recent Progress in the Restoration of Archeological Metallic Artifacts by Means of Low-Pressure Plasma Treatment", aus: Plasma Chemistry and Plasma Processing, Vol. 8, No. 4, 1988, wonach Oberflächen archäologischer metallischer Funde in einer Plasmaentladung in wasserstoffenthaltender Atmosphäre konserviert werden;

- K. Pickering et al., "Hydrogen plasmas for flux free flip-chip solder bonding", aus: J.Vac.Sci.Technol. A8(3), May/June 1990, American Vacuum Society, wonach Pb-Sn-Löten in einem Mikrowellenplasma in Wasserstoff enthaltender Atmosphäre vorgenommen wird;

- V. Zhukov et al., "Coadsorption of hydrogen and potassium on silver single crystal surfaces", aus: Pergamon, Vacuum/volume 47/number 1, 1995, Elsevier Science Ltd., wonach festgestellt wurde, dass, durch Wasserstoffadsorption, Edelmetall-Oberflächen passiviert werden;

- N. Koopman et al., "Fluxless Soldering in Air and Nitrogen", aus: I.N., 1993 Proceedings, 43rd Electronic Components and Technology Conference (Cat.No. 93CH3205/2), Proceedings of IEEE, 43rd Electronic Components and Technology Conference (ECTC'93), Orlando, 1st to 4th June 1993, woraus es bekannt ist, Oxide an einer Lotoberfläche in Oxifluoride zu wandeln. Damit werde eine hohe Passivierung gegenüber Luft erreicht, so dass so behandelte Oberflächen bis zu einer Woche an Luft gelagert werden könnten, vor reflow-Verbindung.

Die Erfindung mit bevorzugten Ausführungsformen bzw. Verwendungen, wie sie in den Ansprüchen 14 bis 21 spezifiziert sind, wird anschliessend anhand eines besonders bevorzugten Beispiels erläutert.

In den Figuren zeigen:

Fig. 1 schematisch, den Aufbau einer erfindungsgemässen Anlage, wie sie für die beschriebenen Versuche eingesetzt wurde;

Fig. 2 die Auger-Spektren zweier lead frame-Oberflächen von Weichlotsubstraten, welche aus derselben Verpackungseinheit stammen und darin unterschiedliche Abstände zum Verpackungsmaterial hatten;

Fig. 3 die Auger-Spektren von Oberflächen für die Erstellung einer Weichlotverbindung, unvorbehandelt (a), erfindungsgemäss vorbehandelt (b) sowie erfindungsgemäss vorbehandelt und darnach Luft ausgesetzt (c);

Fig. 4 schematisch, die Definition der Scherungsbelastung und der Zugbelastung von wire-bond-Verbindungsstellen;

Fig. 5 in Funktion der Behandlungszeit zu verbindender erfindungsgemässer Oberflächen für wire bonding sowie des Druckes bei der erfindungsgemässen Oberflächenbehandlung, die Zugbelastbarkeit erfindungsgemäss behandelter, luftgelagerter und anschliessend Ultraschall-wire-gebondeter Oberflächen von QFP (Quad Flat Pack) Cu lead frames mit versilberten leads (Kontakten);

Fig. 6 in Abhängigkeit der Bond-Temperatur, die Zugbelastbarkeit Ultraschall-gebondeter, unvorbehandelter sowie erfindungsgemäss vorbehandelter und gelagerter Oberflächen.

Das erfindungsgemäss zur Konservierung verwendete Reinigungsverfahren sowie das erfindungsgemäss vorgeschlagene Verbindungsverfahren können, wenn mit Plasmaaktivierung des Wasserstoffes durchgeführt, grundsätzlich in Plasmen durchgeführt werden, welche DC-, AC-, bis hin zu Mikrowellenfrequenzen, oder gemischt, AC+DC, unterhalten werden.

Bevorzugterweise werden aber hierfür Niederspannungs-Bogenentladungen eingesetzt. Anlagen der bevorzugterweise eingesetzten Art sind bekannt aus z. B.:

- DE-OS-43 10 941, entsprechend der US-5 384 018;

- der DE-40 29 270, entsprechend der EP-478 909 bzw. der DE-4 029 268 entsprechend der US-5 336 326;

- der EP-510 340, entsprechend der US-5 308 950.

Diese nur beispielsweise aufgeführten Schriften zeigen alle Behandlungskammern für Werkstücke unter Einsatz von Niederspannungs-Bogenentladung. Bezüglich der Ausbildung solcher Behandlungskammern sollen diese Schriften integrierter Teil der vorliegenden Beschreibung bilden.

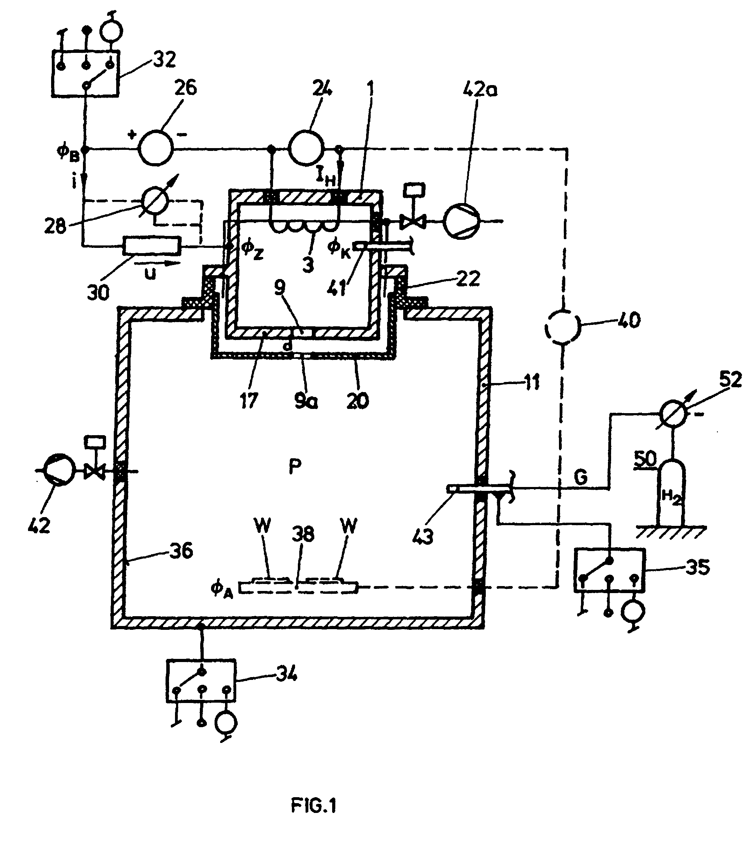

In Fig. 1 ist eine bevorzugte Anlage für den Einsatz gemäss vorliegender Erfindung dargestellt. In einer Kathodenkammer 1 ist eine thermionische Kathode 3 isoliert montiert. Partien 17 der Kathodenkammer 1 umranden eine Blendenöffnung 9. Die Kathodenkammer 1 ist über Isolationsträger 22 an der Wand der Behandlungskammer 11 montiert. Es umschliesst ein Schirm 20, der sowohl bezüglich Kathodenkammer 1 wie auch bezüglich Behandlungskammer 11 potentialschwebend betrieben wird, die Partien 17 auf Dunkelraumabstand d bis unmittelbar in den Bereich der Blendenöffnung 9. Die thermionische Kathode wird mittels einer Quelle 24 mit dem Heizstrom $I_H$ betrieben und ist über eine Spannungsquelle 26 und, generell gesprochen, eine Einheit 28 auf mindestens einen Teil der Kathodenkammerwand geführt, bevorzugterweise auf die Kathodenkammerwand selbst. Die Einheit 28 wirkt als Strombegrenzung und bewirkt in Funktion des sie durchfliessenden Stromes i einen Spannungsabfall u. Sie kann, wie gestrichelt dargestellt, durch eine stromgesteuerte Spannungsquelle realisiert sein, wird aber bevorzugterweise durch ein passives Schaltelement, dabei insbesondere durch ein Widerstandselement 30, realisiert.

Der positive Pol der Spannungsquelle 26 kann auf ein Bezugspotential, sei dies Masse, oder ein weiteres vorgegebenes Potential gelegt werden oder kann potentialfrei betrieben werden, wie dies rein schematisch durch den Möglichkeitsumschalter 32 dargestellt ist. Desgleichen kann, da von der Kathodenkammer 1 elektrisch isoliert, die Behandlungskammer 11, wie mit dem Möglichkeitsumschalter 34 rein schematisch dargestellt, auf Massepotential, auf einem Bezugspotential oder gegebenenfalls sogar potentialschwebend betrieben werden. Die Behandlungskammer-Innenwand 36 oder mindestens Partien davon können bezüglich der thermionischen Kathode 3 als Anode geschaltet sein; bevorzugterweise wird aber eine separate Anode 38, wie gestrichelt dargestellt, vorgesehen, welche über eine Spannungsquelle 40 mit Bezug auf die thermionische Kathode 3 anodisch, d.h. positiv, beschaltet wird. Die Anode 38 wird dabei bevorzugterweise als Werkstückträger für die schematisch eingetragenen Werkstücke W verwendet. Der Kathodenkammer wird über Gaszuspeiseleitung 41 ein Arbeitsgas, beispielsweise und vorzugsweise Argon, zugeführt. Ueber eine weitere, schematisch dargestellte Gaszuspeiseleitung 43, wie mit dem Möglichkeitsschalter 35 schematisch dargestellt, je nach Potentiallegung der Kammer 11 auf Potential legbar, wird das wasserstoffenthaltende Gas G, vorzugsweise Wasserstoff, zugeführt. Das Gas G wird über ein schematisch dargestelltes Ventil 52 eingelassen.

Eine Pumpanordnung 42 ist vorgesehen, um die Kammer 11 und gegebenenfalls die Kathodenkammer 1 abzupumpen, wobei, wie dargestellt, zusätzlich eine Pumpanordnung 42a vorgesehen sein kann, um die Kathodenkammer getrennt abzupumpen. Die Blendenanordnung mit der Blendenöffnung 9 wirkt als Druckstufe zwischen Druck in der Kathodenkammer 1 und Druck in der Behandlungskammer 11. Der Pumpanordnung 42 kann ein Verdünnungsgas, z.B. $N_2$, zugespiesen werden. Damit kann ein Stickstofffluss erzeugt werden, welcher den Wasserstoff auf weniger als 4Vol% im Gas reduziert bzw. verdünnt, damit das Gas ohne Bedenken in die Umwelt abgegeben werden kann. Es liegt kein zündbares, explosives Gas mehr vor.

Der Partialdruck des wasserstoffenthaltenden Gases G kann in der Behandlungskammer 11 wesentlich höher gehalten werden als in der Kathodenkammer 1, was ermöglicht, die Standzeit der thermionischen Kathode 3 wesentlich zu erhöhen. Es bildet die Wand der Kathodenkammer 1 Zündelektrode: Zum Zünden der Niederspannungsentladung wird die thermionische Kathode 3 zur Elektronenemission mit dem Heizstrom $I_H$ aufgeheizt, und es wird Argon in die Kathodenkammer eingelassen. Auf Grund der Abstandsrelation zwischen Wand der Kathodenkammer 1 und der Kathode 3 erfolgt durch Potentiallegung letzterer die Zündung der Entladung, worauf ein Strom i durch die Einheit 28, insbesondere den Widerstand 30, fliesst. Damit reduziert sich das vormals auf Zündwert liegende Potential $\Phi_Z$ der Kathodenkammerwand 17, womit im Betrieb die Wandung der Kammer 1 nur noch in vernachlässigbarem Masse als Anode wirkt und die Primärentladung durch die Blendenanordnung mit der Oeffnung 9 auf die behandlungskammerseitige Anode 38 gezogen wird.

Mit einer wie in Fig. 1 dargestellten Kammer wurden die Oberflächen zu verbindender Werkstücke behandelt. Es kann sich dabei z.B. um

- metallische lead frames für Weichloten, beispielsweise aus Cu, vernickeltem Cu, silberplattiertem Cu,

- organische HLST-Materialien, wie BGA (ball grid arrays) und MCM (multi chip modules), beispielsweise auf Epoxy- oder Esterbasis, sowie PCB (printed chip boards),

- metallische QFP (quad flat packe), beispielsweise aus Cu, versilbertem CU, Pd-plattiertem Cu,

- die Metallisierung der Leiterbahnen für die organischen HLST-Materialien und die QFP, beispielsweise aus versilbertem Cu, vergoldetem Cu, Au,

- Halbleitersubstratträger als Flip Chip ausgebildet mit Lötpunkten, beispielsweise aus AgSn, PbSn, PbSnAg, PbInAg,

- HLST-Materialien auf Keramikbasis, beispielsweise Aluminiumoxid,

- Oberflächenschutzschicht der Chips, beispielsweise aus Siliziumnitrid, Siliziumoxinitrid, Polyimid,

handeln.

Behandlungsbeschreibung:

Die Behandlungskammer gemäss Fig. 1, welche für die zu beschreibenden Versuche verwendet wurde, hatte ein Volumen von

$$V \simeq 60 \text{ L.}$$

Die Werkstücke oben angegebener Art wurden in die Kammer eingeführt und letztere wie folgt betrieben:

1. Abpumpen auf Basisdruck von ca. $10^{-5}$mbar;

2. Aktivierung der Kathode 3 mit $I_H$ ca. 150A;
   Einschalten der Gasflüsse:

- Argon durch Leitung 41,
  Fluss $Fl_{Ar}$ : 10sccm $\leq Fl_{Ar} \leq$ 50sccm,

- Wasserstoff durch Leitung 43,
  Fluss $Fl_{H2}$ : 10sccm $\leq Fl_{H2} \leq$ 50sccm.

3. Nach ca. 10sec Aufheizzeit wurde Zündspannung zwischen Kathode 3 und Zündelektrode 17 gelegt. Der Widerstand 30 wurde zu ca. $20\Omega$ gewählt und auf Masse gelegt. Nach Zünden der Entladung (Zündspannung ca. 20V bis 30V) stellt sich eine Entladungsspannung zwischen Kathode 3 und Anode 38 von ca. 25V bei 40A Entladestrom ein, unter bevorzugter Verwendung eines Schweissgenerators, wenn die Rezipientenwandung 11 auf Masse als Anode 38 eingesetzt wird. Es werden Ionen und angeregte Neutrale erzeugt, wofür das typische Plasmaleuchten Indiz ist. Die zu behandelnden Werkstücke wurden in dem so erzeugten Plasma oberflächenbehandelt. Die Wasserstoffflüchtigen Verbindungen mit Verunreinigungen wurden mit der Pumpanordnung 42 abgepumpt.

Der Arbeitsdruck betrug:

$$\text{ca. } 6 \cdot 10^{-3} \text{mbar.}$$

Nebst der Halterung der Werkstücke auf Massepotential, können letztere auch potentialfliegend oder auf ein Referenzpotential gelegt der Plasmabehandlung ausgesetzt sein. Dadurch, dass das Potential der Werkstücke bezüglich Massepotential in der beschriebenen Niederspannungsentladung sehr niedrig ist, < 30V, wird sowohl das Problem der Redeposition von Material auf den Werkstücken, zu der es beim sogenannten Sputtern kommt, wie auch, und insbesondere, die Gefahr der Zerstörung von bezüglich elektrischen Potentialdifferenzen kritischen ICs ausgeschlossen. Die Reinigung und Konservierung erfolgt allein über chemische Prozesse, die entweder durch Elektronen, bei entsprechend potentialgelegten Werkstücken, oder durch niederenergetische Ionen und Elektronen bei fliegend ; (floatend) betriebenen Werkstücken bewirkt wird.

Die grosse Zahl in das Plasma eingekoppelter Elektronen sichert eine hohe Reaktivität des Plasmas, damit kurze Behandlungszeiten, was massgeblich zur Wirtschaftlichkeit des vorgeschlagenen Vorgehens beiträgt. Ein weiterer Vorteil dieses Vorgehens besteht darin, dass das Plasma sogar in kleine Hohlräume eindringen kann. Damit können z.B. Werkstücke ohne Entnahme aus entsprechenden Kassetten bzw. Magazinen behandelt werden, was besonders wirtschaftlich ist.

Resultate:

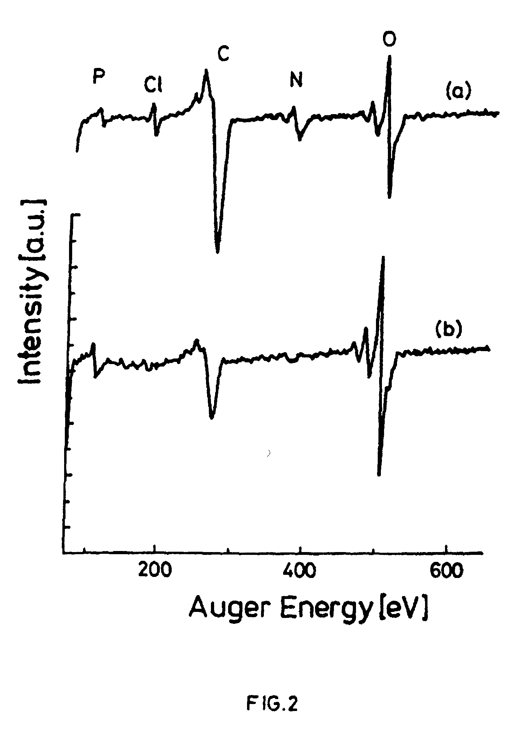

In Fig. 2 sind Auger-Diagramme dargestellt,

- (a) einer unbehandelten lead frame-Kupferoberfläche für Weichlotverbindung nach Kontaktierung mit einem Verpackungsmaterial;

- (b) einer solchen Oberfläche innerhalb derselben Verpackungseinheit, aber nicht in Kontakt mit dem Verpackungsmaterial.

Die lead frame-Oberfläche, die mit dem Verpackungsmaterial in Kontakt stand (b), ist auf Grund ihrer hohen Verunreinigung praktisch unlötbar.

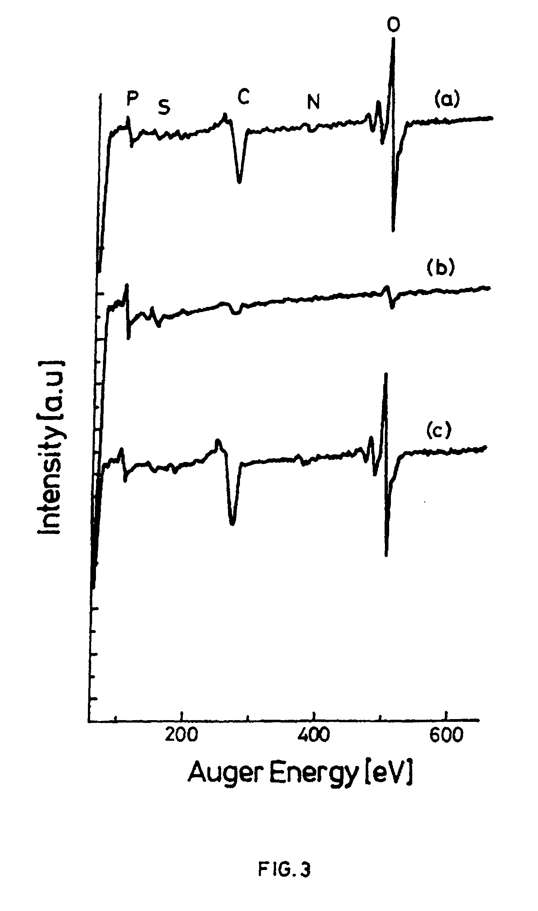

In Fig. 3 sind Auger-Diagramme dargestellt,

- (a) unbehandelter lead-frame-Oberflächen für Weichlotverbindung,

- (b) solcher nach oben beschriebenen Vorgehen behandelten Oberflächen unmittelbar nach deren Behandlung und

- (c) solcher Oberflächen nach Kurve (b), aber nach deren Lagerung während ca. 1h und mehr in Luft.

Es ist ersichtlich, dass sich die Auger-Diagramme unbehandelter einerseits, behandelter und nachmals Luft ausgesetzter Oberflächen anderseits kaum unterscheiden.

Obwohl, wie in Fig. 3 gezeigt, sich die Auger-Diagramme ungereinigter und nach dem erwähnten Verfahren gereinigter und wieder an Luft gebrachter Metalloberflächen kaum unterscheiden, benetzt das Lot bei letzteren die lead frame-Oberflächen wesentlich besser als für ungereinigte lead frames, was zu einer innigeren Verbindung zwischen Halbleiter und Träger führt. Quantitativ lässt sich dieser Reinigungseffekt besonders deutlich an den guten Belastungsresultaten beim Draht-Bonden illustrieren.

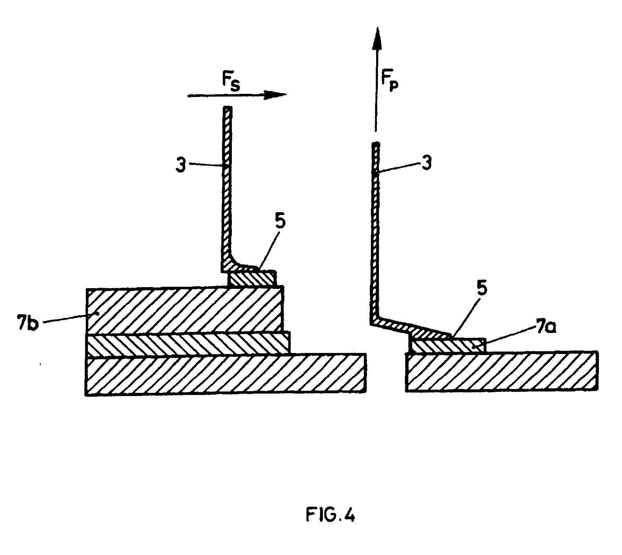

In Fig. 4 sind die Testbeanspruchungen für wire bonding definiert. Die Belastung $F_S$ eines dünnen Drahtes 3, dessen Oberfläche an einer Verbindungsstelle 5 mit der Oberfläche eines lead frames 7a bzw. chips 7b verbunden ist, wird als Scherbelastung bezeichnet, während die Belastung Fp als Zugbelastung bezeichnet wird.

Es wurden weiter unbehandelte Oberflächen von QFP lead frames mit silberplattierten Cu-leads, analog zu (a) von Fig. 3, sowie solche behandelte Oberflächen nach (c) von Fig. 3 drahtgebondet (wire bonding).

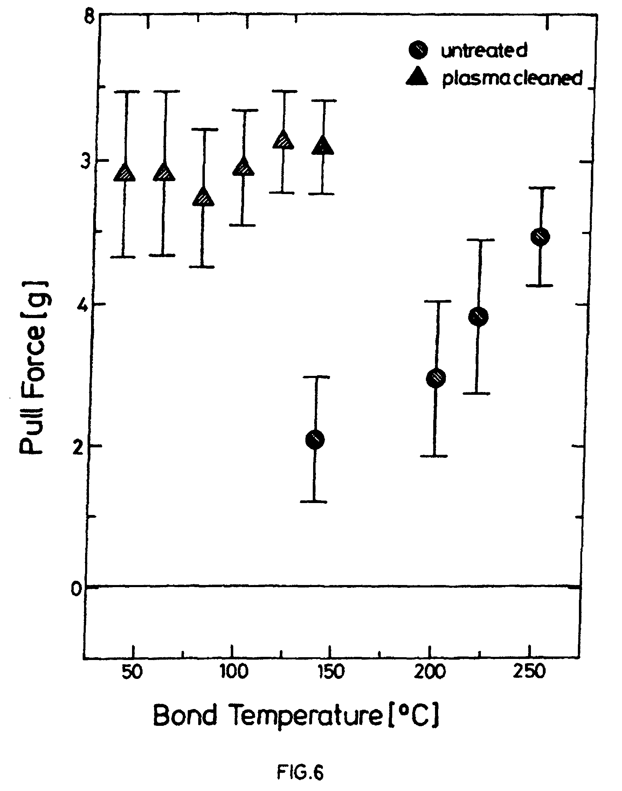

Als Bond-Parameter wurde eine Ultraschallfrequenz von 100kHz und eine Bond-Temperatur von ca. 150°C eingesetzt (s. auch Fig. 6).

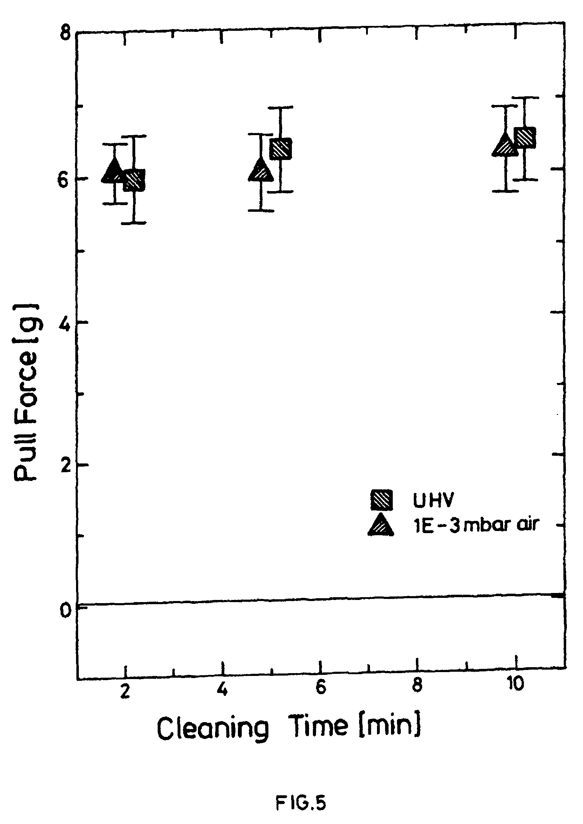

Während die Oberflächen nach (a) von Fig. 3 bei diesen tiefen Temperaturen praktisch unbondbar waren, ergaben sich für die Oberflächen nach (c) von Fig. 3 Zugbelastbarkeiten gemäss Fig. 5, in Abhängigkeit von der Behandlungszeit im Plasma und vom Anfangsdruck, auf welchen die Behandlungskammer nach Fig. 1 vor Gaseinlass abgepumpt wurde. Daraus ist ersichtlich, dass einerseits die Belastbarkeit mit steigender Behandlungszeit nur unwesentlich steigt, womit bereits sehr kurze Behandlungszeiten von 2min und darunter ausgezeichnete Resultate liefern.

Bezüglich des Anfangsdruckes ist ersichtlich, dass auch eine , Erhöhung des Druckes auf beispielsweise $10^{-3}$mbar nur unwesentlich die Zugbelastbarkeit beeinflusst, womit der Aufwand an der eingesetzten Anlage für Ultra-Hochvakuumpumpen reduziert werden kann.

In Fig. 6 sind die Zugbelastbarkeiten der Ultraschall-gebondeten Oberflächen nach (c) von Fig. 3 dargestellt, in Abhängigkeit von Bond-Temperatur, wobei diese so hoch getrieben wurde, dass auch die unbehandelten Oberflächen nach (a) von Fig. 3 bondbar wurden. Es ist augenfällig, dass einerseits für die erfindungsgemäss behandelten Oberflächen wesentlich tiefere Bond-Temperaturen ausreichen zum Erhalt wesentlich höherer Zugbelastbarkeiten, verglichen mit unbehandelten, gleichen Werkstück-Oberflächen.

Im weiteren ist die Bond-Qualität der erfindungsgemäss behandelten Oberflächen weitestgehend temperaturunabhängig, was den Aufwand für die Temperaturbeherrschung beim Bonden wesentlich reduziert. Dass erfindungsgemäss tiefe Bond-Temperaturen eingesetzt werden können, ist besonders wichtig, beispielsweise für "Ball Grid" arrays HLST aus organischem Material, welche bei tiefen Temperaturen ≤ 150°C gebondet werden müssen.

Die in Fig. 6 erfindungsgemäss einsetzbaren Bond-Temperaturen sind wesentlich tiefer als die Bond-Temperaturen, die üblicherweise eingesetzt werden. Es kann heute nur vermutet werden, dass die erfindungsgemässe Behandlung die Konservierung dadurch bewirkt, dass die Metalloberfläche durch Wasserstoff abgesättigt wird, sich Verunreinigungen auf der Oberfläche abscheiden und praktisch auf der Wasserstoffabdeckung schwimmen, so dass ihre Charakteristik im Auger-Diagramm - in dem Wasserstoff nicht oder nur indirekt und schwierig nachgewiesen werden kann - nach Luftaussetzung praktisch wie ungereinigt erscheint, jedoch für das Bonden bzw. Verbinden wie hoch qualitativ gereinigt. Beim Zuführen der Verbindungsenergie, z.B. Ultraschall bei Bonden, werden die konservierenden Wasserstoffbindungen offensichtlich leicht aufgebrochen und die reine Metalloberfläche für die Verbindung freigelegt.

Das Diagramm nach Fig. 3(c) zusammen mit der qualitativ hochstehenden Verbindbarkeit nach Fig. 5, 6 kennzeichnen die erfindungsgemässen Oberflächenpaare gegenüber Paaren nach Fig., 3(a) und deren schlechte Verbindbarkeit nach Fig. 6.

Ungereinigte HLST zeigten Zugbelastungswerte der angebondeten Drähte von weniger als 5cN, während für die erfindungsgemäss oberflächenbehandelten Werte von über 6cN zu beobachten waren. In den meisten Fällen riss der Draht, ehe es zum Reissen der Verbindungsstelle kam.

Es hat sich im weiteren gezeigt, dass auch für die weiteren, oben erwähnten Schritte beim Verpakkungsprozess integrierter Schaltkreise sich die Oberflächenbehandlung in aktiviertem Wasserstoff für die zu erstellenden Verbindungen äusserst günstig auswirkt. Auch bei HLST-Materialien auf Kunststoff-basis wurde beobachtet, dass nach dem Vergiessen (moulding) die Vergussmasse nur ungenügend auf den HLST haftet, jedoch nach erfindungsgemässer Vorbehandlung in aktiviertem Wasserstoff, dabei insbesondere plasmaaktiviertem, sich ein inniger Verbund von Vergussmasse und in aktiviertem Wasserstoff gereinigten HLST-Oberfläche ergibt. Auch hier kann der Konservierungseffekt der Behandlung mit aktiviertem Wasserstoff beobachtet werden, d.h. die behandelten HLST können mehrere Tage, beispielsweise fünf Tage, nach der Reinigung noch hervorragend gebondet und vergossen werden.

**Patentansprüche**

1. Verfahren zur Herstellung von Werkstücken, bei dem Oberflächen von Teilen Luft ausgesetzt werden und danach ohne weitere zusätzliche Behandlung gebondet, geklebt oder vergossen werden und sie hierfür vor dem Luftaussetzen einer Atmosphäre mit aktiviertem Wasserstoff ausgesetzt werden.

2. Verfahren nach Anspruch 1, **dadurch gekennzeichnet, dass** man den Wasserstoff der Atmosphäre mittels einer Plasmaentladung oder mittels Licht, insbesondere mittels UV-Strahlung, aktiviert.

3. Verfahren nach einem der Ansprüche 1 oder 2, bei dem die Oberflächen metallisch, halbmetallisch oder aus Kunststoff sind, bevorzugterweise metallisch.

4. Verfahren nach einem der Ansprüche 1 bis 3, **dadurch gekennzeichnet, dass** man den Wasserstoff mittels einer Niederspannungsentladung anregt.

5. Verfahren nach Anspruch 4, **dadurch gekennzeichnet, dass** man die Niederspannungsentladung mittels einer thermionischen Kathode betreibt.

6. Verfahren nach einem der Ansprüche 1 bis 5, **dadurch gekennzeichnet, dass** man als Atmosphäre eine Vakuumatmosphäre wählt.

7. Verfahren nach einem der Ansprüche 1 bis 6, **dadurch gekennzeichnet, dass** man in der Atmosphäre eine Plasmaentladung unterhält und die Atmosphäre ein Arbeitsgas enthält, vorzugsweise Argon.

8. Verfahren nach einem der Ansprüche 1 bis 7, **dadurch gekennzeichnet, dass** man den Wasserstoff mittels einer Plasmaentladung aktiviert in einer ausschliesslich Wasserstoff und ein Arbeitsgas für die Entladung enthaltenden Atmosphäre.

9. Verfahren nach einem der Ansprüche 1 bis 8, **dadurch gekennzeichnet, dass** man den Wasserstoff mittels einer Plasmaentladung anregt, deren Entladespannung kleiner als 30V ist und die einen Entladestrom vorzugsweise zwischen 10A und 100A aufweist.

10. Verfahren nach einem der Ansprüche 1 bis 9, **dadurch gekennzeichnet, dass** die Oberflächen ultraschallverschweisst werden.

11. Verfahren nach einem der Ansprüche 1 bis 10, **dadurch gekennzeichnet, dass** man die Oberfläche mindestens eines der Halbfabrikate auf höchstens 150°C erhitzt.

12. Verwendung des Verfahrens nach einem der Ansprüche 1 bis 11 für die Herstellung von Werkstücken durch Verbinden integrierter Schaltkreis mit einem HLST oder durch elektrisches Kontaktieren integrierter Schaltkreise durch Wire Bonding oder durch Umhüllen von mit HLST verbundenen, durch Wire Bonding kontaktierten, elektrischen Schaltkreisen mit einer Gussmasse.

13. Verwendung des Verfahrens nach einem der Ansprüche 1 bis 11 für Flip Chip zu verbindende und zu positionierende integrierte Schaltkreise und HLST, durch Aufschmelzen von Lötpunkten von Schaltkreis und HLST.

14. Verwendung einer Behandlung von Teilen, bei der die Teile einer Atmosphäre mit aktiviertem Wasserstoff ausgesetzt werden, für das Erreichen einer Bond-, Kleb- oder Vergiessbarkeit der Teile ohne zusätzliche Behandlung, nachdem die Teile, nach der Wasserstoffbehandlung, Luft ausgesetzt sind.

15. Verwendung nach Anspruch 14, **dadurch gekennzeichnet, dass** die Oberfläche metallisch, halbmetallisch oder eine Kunststoff-Oberfläche ist, insbesondere eine metallische.

16. Verwendung nach einem der Ansprüche 14 oder 15, **dadurch gekennzeichnet, dass** man die Entladung in einer Arbeitsgas enthaltenden Atmosphäre unterhält, vorzugsweise in einer Argon enthaltenden.

17. Verwendung nach Anspruch 16, **dadurch gekennzeichnet, dass** die Atmosphäre ausschliesslich Wasserstoff und das Arbeitsgas enthält.

18. Verwendung nach einem der Ansprüche 14 bis 17, **dadurch gekennzeichnet, dass** die Entladespannung kleiner als 30 V ist und die Entladung einen Entladestrom vorzugsweise zwischen 10 A und 100 A hat.

19. Verwendung nach einem der Ansprüche 14 bis 18, **dadurch gekennzeichnet, dass** die ultraschallverschweisst werden können.

20. Verwendung nach einem der Ansprüche 14 bis 19, **dadurch gekennzeichnet, dass** die Teile höchstens auf 150°C erhitzt werden dürfen.

21. Verwendung des Verfahren nach einem der Ansprüche 14 bis 20 für integrierte Schaltkreise oder HLST.

**Claims**

1. Process for manufacturing workpieces in which surfaces of components are exposed to air and then bonded, glued or cast without further treatment and for this before exposure to air are exposed to an atmosphere with activated hydrogen.

2. Process according to claim 1, **characterised in that** the hydrogen of the atmosphere is activated by means of a plasma discharge or by means of light, in particular by means of UV radiation.

3. Process according to one of claims 1 to 2, in which the surfaces are metallic, semi-metallic or made of plastic, preferably metallic.

4. Process according to any of claims 1 to 3, **characterised in that** the hydrogen is excited by means of a low voltage discharge.

5. Process according to claim 4, **characterised in that** the low voltage discharge is operated by means of a thermionic cathode.

6. Process according to any of claims 1 to 5, **characterised in that** as an atmosphere a vacuum atmosphere is selected.

7. Process according to any of claims 1 to 6, **characterised in that** a plasma discharge is maintained in the atmosphere and the atmosphere contains a working gas, preferably argon.

8. Process according to any of claims 1 to 7, **characterised in that** the hydrogen is activated by means of a plasma discharge in an atmosphere containing exclusively hydrogen and a working gas for the discharge.

9. Process according to any of claims 1 to 8, **characterised in that** the hydrogen is excited by means of a plasma discharge, the discharge voltage of which is less than 30 V and which has a discharge current preferably between 10A and 100A.

10. Process according to any of claims 1 to 9, **characterised in that** the surfaces are ultrasonic-welded.

11. Process according to any of claims 1 to 10, **characterised in that** the surface of at least one of the semi-finished products is heated to maximum 150°C.

12. Use of the process according to any of claims 1 to 11 for the production of workpieces by connection of integrated circuits with an HLST or by electrical contacting of integrated circuits by wire bonding or by encasing with a casting compound electrical circuits bonded with HLST and contacted by wire bonding.

13. Use of the process according to any of claims 1 to 11 for flip chip integrated circuits and HLST to be connected and positioned by melting solder points on the circuit and HLST.

**14.** Use of a component treatment in which the components are exposed to an atmosphere with activated hydrogen to achieve a capacity of the components to be bonded, glued or cast without further treatment, after the components are exposed to air after the hydrogen treatment.

**15.** Use according to claim 14, **characterised in that** the surface is a metallic, semi-metallic or a plastic surface, in particular metallic.

**16.** Use according to one of claims 14 or 15, **characterised in that** the discharge is maintained in an atmosphere containing a working gas, preferably argon.

**17.** Use according to claim 16, **characterised in that** the atmosphere contains exclusively hydrogen and the working gas.

**18.** Use according to any of claims 14 to 17, **characterised in that** the discharge voltage is less than 30 V, and the discharge has a current preferably between 10 A and 100 A.

**19.** Use according to any of claims 14 to 18, **characterised in that** the components can be ultrasonic-welded.

**20.** Use according to any of claims 14 to 19, **characterised in that** the components may be heated to maximum 150°C.

**21.** Use of the process according to any of claims 14 to 20 for integrated circuits or HLST.


**Revendications**

**1.** Procédé pour fabriquer des pièces, selon lequel les surfaces d'éléments sont exposées à l'air, sont ensuite soudées, collées ou scellées sans traitement supplémentaire et sont exposées pour cela, avant d'être exposées à l'air, à une atmosphère contenant de l'hydrogène activé.

**2.** Procédé selon la revendication 1, **caractérisé en ce qu'**on active l'hydrogène de l'atmosphère à l'aide d'une décharge de plasma ou de lumière, en particulier à l'aide d'un rayonnement UV.

**3.** Procédé selon la revendication 1 ou 2, selon lequel les surfaces sont en métal, en métalloïde ou en matière plastique, de préférence en métal.

**4.** Procédé selon l'une des revendications 1 à 3, **caractérisé en ce qu'**on active l'hydrogène à l'aide d'une décharge basse tension.

**5.** Procédé selon la revendication 4, **caractérisé en ce qu'**on fait fonctionner la décharge basse tension à l'aide d'une cathode thermo-ionique.

**6.** Procédé selon l'une des revendications 1 à 5, **caractérisé en ce qu'**on choisit comme atmosphère une atmosphère sous vide.

**7.** Procédé selon l'une des revendications 1 à 6, **caractérisé en ce qu'**on entretient une décharge de plasma dans l'atmosphère, et l'atmosphère contient un gaz de travail, de préférence de l'argon.

**8.** Procédé selon l'une des revendications 1 à 7, **caractérisé en ce qu'**on active l'hydrogène à l'aide d'une décharge de plasma dans une atmosphère contenant uniquement de l'hydrogène et un gaz de travail pour la décharge.

**9.** Procédé selon l'une des revendications 1 à 8, **caractérisé en ce qu'**on active l'hydrogène à l'aide d'une décharge de plasma dont la tension de décharge est inférieure à 30 V et qui présente un courant de décharge situé de préférence entre 10 A et 100 A.

**10.** Procédé selon l'une des revendications 1 à 9, **caractérisé en ce que** les surfaces sont soudées par ultrasons.

**11.** Procédé selon l'une des revendications 1 à 10, **caractérisé en ce qu'**on chauffe la surface de l'un au moins des produits semi-finis à 150°C maximum.

**12.** Utilisation du procédé selon l'une des revendications 1 à 11 pour fabriquer des pièces en reliant des circuits intégrés à un support de système semi-conducteur ou en réalisant le contact électrique de circuits intégrés par connexion par fils ou enrobage, avec une masse de remplissage, de circuits électriques reliés à un support de système semi-conducteur et connectés par fils.

**13.** Utilisation du procédé selon l'une des revendications 1 à 11 pour des circuits intégrés et des supports de système semi-conducteur à relier et positionner selon la technique des puces à bosses, grâce à la fusion de points de brasage du circuit et du support.

**14.** Utilisation d'un traitement d'éléments selon laquelle les éléments sont exposés à une atmosphère avec de l'hydrogène activé, pour obtenir une capacité de soudage, de collage ou de scellage des éléments sans traitement supplémentaire, après que les éléments, après le traitement par hydrogène, ont été exposés à l'air.

**15.** Utilisation selon la revendication 14, **caractérisée en ce que** la surface est une surface en métal, en métalloïde ou en matière plastique, en particulier une surface en métal.

**16.** Utilisation selon la revendication 14 ou 15, **caractérisée en ce qu'**on entretient la décharge dans une atmosphère contenant un gaz de travail, de préférence de l'argon

**17.** Utilisation selon la revendication 16, **caractérisée en ce que** l'atmosphère contient uniquement de l'hydrogène et le gaz de travail.

**18.** Utilisation selon l'une des revendications 14 à 17, **caractérisée en ce que** la tension de décharge est inférieure à 30 V et la décharge a un courant de décharge situé de préférence entre 10 A et 100 A.

**19.** Utilisation selon l'une des revendications 14 à 18, **caractérisée en ce que** les éléments peuvent être soudés par ultrasons.

**20.** Utilisation selon l'une des revendications 14 à 19, **caractérisé en ce que** les éléments peuvent être chauffés au maximum à 150°C.

**21.** Utilisation du procédé selon l'une des revendications 14 à 20 pour des circuits intégrés ou des supports de système semi-conducteur.

FIG.1

FIG.2

FIG. 3

FIG. 4

FIG.5

FIG.6